# EUROPEAN PATENT APPLICATION

(11) **EP 4 730 653 A1**
(43) Date of publication of application: **22.04.2026**
(21) Application number: 25206910.9
(22) Date of filing: 06.10.2025
(51) Int. Cl.: H03L 7/00, H03L 7/181, G06F 1/12

(54) **REFERENCE CLOCK GENERATING CIRCUIT**

(30) Priority: 16.10.2024 KR 20240141392
(71) Applicant: SKAIChips Co., Ltd., Suwon-si, Gyeonggi-do 16571 (KR); Research & Business Foundation Sungkyunkwan University, Gyeonggi-do 16419 (KR)
(72) Inventor: Lee, Kang Yoon, 04974 Seoul (KR); Kim, Ho Won, 16361 Suwon-si, Gyeonggi-do (KR); Kim, Ji Hun, 16417 Suwon-si, Gyeonggi-do (KR); Jung, Jae Hyung, 16421 Suwon-si, Gyeonggi-do (KR); Kim, Sung Jin, 16636 Suwon-si, Gyeonggi-do (KR); Pu, Young Gun, 16684 Suwon-si, Gyeonggi-do (KR)
(74) Representative: Grünecker Patent- und Rechtsanwälte PartG mbB

(57) **Abstract**

Disclosed is a technology related to semiconductor circuits, and particularly, to circuits for generating a reference clock from a radio signal. A window in which an external signal, which is input to control a frequency according to a difference between an output of a digitally controlled oscillating circuit and a target frequency is considered in terms of circuits, is dynamically controlled. A reference clock generating circuit can vary a frequency of an output reference clock by selecting a target count value of a frequency counter as one of a plurality of sets according to an operating mode. The reference clock generating circuit can be controlled to block power from being supplied to the circuit when the output is stably locked to the target frequency, and the digitally controlled oscillating circuit is allowed to be controlled to perform free running by a last input oscillation control word.

## Description

### CROSS-REFERENCE TO RELATED APPLICATION(S)

This application claims priority from Korean Patent Application No. 10-2024-0141392, filed on October 16, 2024, in the Korean Intellectual Property Office, the disclosure of which is incorporated herein by reference in its entirety.

### BACKGROUND

### 1. Field

Disclosed is a technology related to semiconductor circuits, and particularly to circuits for generating a reference clock from a radio signal.

### 2. Description of Related Art

An electronic device, particularly a communication device, requires a reference clock for the synchronized operation of internal circuits thereof. For example, in backscatter carrier relay communication through which power is wirelessly supplied to Internet of Things (loT) devices, a circuit that generates a reference clock for transmission and internal operation using a received radio signal is required. Generally, a crystal-based oscillator is used for the reference clock. However, it is difficult to apply the crystal-based oscillator to communication circuits of IoT devices that require ultra-low power consumption. Further, the crystal-based oscillator should be added to an integrated circuit (IC) as an external element and occupies an additional space on a board on which the IC is mounted.

### SUMMARY

This summary is provided to introduce a selection of concepts in a simplified form that are further described below in the Detailed Description. This summary is not intended to identify key features or essential features of the claimed subject matter, nor is it intended to be used as an aid in determining the scope of the claimed subject matter.

The following description relates to a reference clock generating circuit that has low power consumption and may be integrated into an integrated circuit (IC).

The following description also relates to a reference clock generating circuit that does not occupy a physical space on a system board.

The following description also relates to a reference clock generating circuit that is fully integrated to minimize the number of peripheral elements.

The following description also relates to a reference clock generating circuit that may provide a variable reference frequency.

The following description also relates to a reference clock generating circuit that has a similar precision level to a crystal-based oscillator and does not occupy an additional space on a board.

The following description also relates to a reference clock generating circuit that may output a stabilized reference clock in a short period of time.

This summary is provided to introduce a selection of concepts in a simplified form that are further described below in the Detailed Description. This summary is not intended to identify key features or essential features of the claimed subject matter, nor is it intended to be used as an aid in determining the scope of the claimed subject matter.

In one general aspect, a window in which an external signal, which is input to control a frequency according to a difference between an output of a digitally controlled oscillating circuit and a target frequency is considered in terms of circuits, is dynamically controlled.

According to another aspect of the present invention, an internal oscillating circuit of a reference clock generating circuit may be divided into a coarse control part and a fine control part.

According to an additional aspect of the present invention, a proposed reference clock generating circuit may vary a frequency of an output reference clock by selecting a target count value of a frequency counter as one of a plurality of sets according to an operating mode.

According to an additional aspect of the present invention, the reference clock generating circuit may be controlled to block power from being supplied to the circuit when the output is stably locked to the target frequency, and the digitally controlled oscillating circuit may be controlled to perform free running by a last input oscillation control word.

### BRIEF DESCRIPTION OF THE DRAWINGS

FIG. 1 is a block diagram illustrating a configuration of a reference clock generating circuit according to an embodiment.
FIG. 2 is a diagram for describing a mask signal (MASK) for defining a period during which a frequency counter (500) counts an external high-frequency clock.
FIG. 3 illustrates a configuration of an embodiment of a digitally controlled oscillating circuit.
FIG. 4 illustrates a configuration of another embodiment of a digitally controlled oscillating circuit.
FIG. 5 is a block diagram illustrating a configuration of an oscillation control circuit according to still another embodiment.
FIG. 6 is a block diagram illustrating a configuration of a locking control circuit according to yet another embodiment.
FIG. 7 is a flowchart for describing an embodiment of an operation of a locking control circuit.
FIG. 8 is a block diagram illustrating a configuration of a reference clock generating circuit according to yet another embodiment.
FIG. 9 is a graph for describing an example of the timing of control signals in the embodiments described in FIGS. 1 to 8.

Throughout the accompanying drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

The above-described and additional aspects are embodied through embodiments described with reference to the accompanying drawings. It should be understood that various combinations of elements of each embodiment are possible within embodiments or with elements of other embodiments unless otherwise stated or in the case of contradiction. Terms used in this specification and the claims should be interpreted with meanings and concepts which are consistent with the technological scope of the present invention based on the principle that the inventors have appropriately defined concepts of terms in order to describe the present invention in the best way.

Blocks expressed as "circuits" in this specification may be composed of hardware such as dedicated semiconductors, gate arrays, field-programmable gate arrays (FPGAs), etc., or parts thereof. One block or a plurality of blocks may be implemented as a single piece of hardware. As another example, these blocks may be implemented in software by an information processing device in which program instructions stored in memory elements are executed by computational elements. A plurality of blocks may be implemented as part of a program executed on the same computational element. As another example, these blocks may be implemented in a hybrid form, where some individual circuits thereof are hardware and some are software. Further, in software implementation, computational elements may include digital signal processors, computational processors, artificial intelligence processing engines, artificial intelligence processors, graphics processors, or combinations thereof to the extent possible.

Hereinafter, exemplary embodiments of the present invention will be described in detail with reference to the accompanying drawings.

### <Description of the invention according to claim 1>

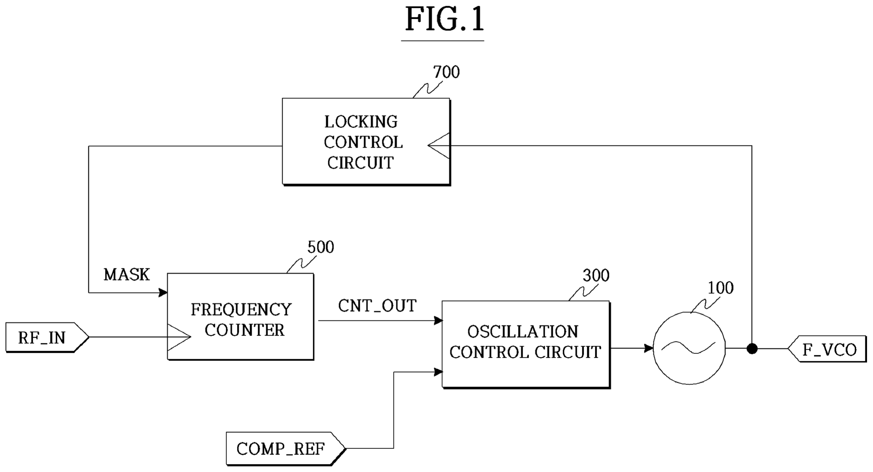

According to the proposed aspect, as an output of a digitally controlled oscillating circuit approaches a target frequency, a window in which an external signal, which is input to control a frequency is considered in terms of circuits, is dynamically controlled. FIG. 1 is a block diagram illustrating a configuration of a reference clock generating circuit according to an embodiment to which this aspect is applied. As illustrated in FIG. 1, the reference clock generating circuit according to an embodiment includes a frequency counter 500, an oscillation control circuit 300, a digitally controlled oscillating circuit 100, and a locking control circuit 700.

The frequency counter 500 counts an external high-frequency clock RF_IN received through a wireless channel during a period for which a mask signal MASK is activated. The received external high-frequency clock may be, for example, a radio frequency signal RF_IN received from an external source by a backscatter carrier relay communication integrated circuit (IC) to which the proposed invention is applied. In the illustrated embodiment, the radio frequency signal RF_IN is a radio frequency signal of 2.4 GHz. The reference clock generating circuit according to an embodiment generates a 32 MHz reference clock signal from the signal RF_IN. When the received external high-frequency clock is accurate, the reference clock signal may be provided by dividing the received external high-frequency clock by 75. However, the received external high-frequency clock is scattered and distorted according to a state of the channel, and thus reference clock recovery is required. However, the present invention is not limited thereto, and the reference clock generating circuit may selectively output a plurality of reference clocks that vary according to an operating mode.

The oscillation control circuit 300 compares an output value CNT_OUT of the frequency counter 500 with a target count COMP_REF and outputs an oscillation control word according to a result of the comparison. In an embodiment, the oscillation control circuit 300 may be implemented as an information processing circuit that includes a memory element, such as a semiconductor memory, in which program instructions are stored, and a computation element, such as a microprocessor, that reads and executes the program instructions. The target count COMP_REF may be predetermined using an output value of the frequency counter 500 when the digitally controlled oscillating circuit oscillates at the target frequency, and reflected as a constant in the program.

The oscillation control word is a control word for controlling an oscillation frequency of the digitally controlled oscillating circuit 100. In an embodiment, it may be formed so that the larger the oscillation control word, the lower the frequency output by the digitally controlled oscillating circuit 100 and the smaller the oscillation control word, the higher the frequency output by the digitally controlled oscillating circuit 100. When the output value of the frequency counter 500 is higher than the target count, the oscillation control word may be adjusted to be a larger value, and when the output value of the frequency counter 500 is lower than the target count, the oscillation control word may be adjusted to be a smaller value.

The digitally controlled oscillating circuit 100 includes a circuit element having a characteristic value that varies according to the oscillation control word. In an embodiment, the digitally controlled oscillating circuit 100 may include a resistor-capacitor (RC) oscillator circuit whose resistance and capacitance values are adjusted according to the oscillation control word. By adjusting the resistance and capacitance values of the RC oscillator circuit according to the oscillation control word, the oscillation frequency of the digitally controlled oscillating circuit 100 may be adjusted. The RC oscillator circuit is advantageous for integration because the RC oscillator circuit does not require an inductor, which occupies a large area in an IC.

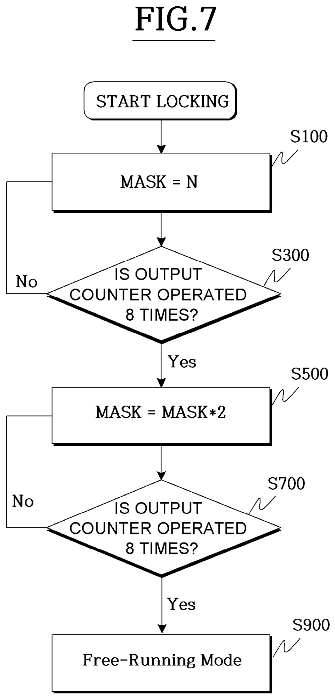

In another embodiment, the digitally controlled oscillating circuit 100 may include an inductor-capacitor (LC) resonant circuit. In an embodiment, the LC resonant circuit may include an array of capacitors of which connection may be controlled by switches, and a resonant frequency thereof may vary by controlling connection using the switches. A digitally controlled oscillating circuit of this structure has been disclosed, for example, in FIG. 7 of U.S. Patent No. 11,374,581, filed and granted by the present applicant.

The locking control circuit 700 dynamically increases an activation period of the mask signal MASK as an output of the digitally controlled oscillating circuit 100 approaches the target frequency. By dynamically adjusting the mask signal, the frequency tracking accuracy, which is the degree to which the output of the digitally controlled oscillating circuit 100 matches the target frequency, may be adjusted.

In an embodiment, the locking control circuit 700 may be implemented as program instructions in an information processing circuit that includes the same memory and computational elements that constitute the oscillation control circuit 300. In the illustrated embodiment, the locking control circuit 700 increases the activation period of the mask signal MASK and also changes a target count value to a larger value. The frequency counter 500 counts an external high-frequency clock input during the activation period of the mask signal MASK, and as a result, the reference clock generating circuit according to an embodiment controls an output frequency of the digitally controlled oscillating circuit 100 according to a result of comparing the number of pulses output for a longer period of time, and thus the frequency matching is performed more precisely, but the time required for the matching becomes longer.

The locking control circuit 700 sets the activation period of the mask signal MASK to be short at the beginning of the circuit's operation to set the target count value to a corresponding small value. In this case, the reference clock generating circuit according to an embodiment may control the output frequency of the digitally controlled oscillating circuit 100 according to a result of comparing the number of pulses output for a shorter period of time, so that the output frequency may be matched to the input target frequency in a short period of time at a rough level. Thereafter, the locking control circuit 700 may more precisely match the output frequency to the target frequency by setting the activation period of the mask signal MASK to be a long period and also setting the target count value to a corresponding large value. However, in this case, since the output frequency is already matched to the target frequency at a rough level based on the results of the previous operation, the output frequency may reach the target frequency more rapidly. Such a process may be repeatedly applied multiple times according to the required clock frequency precision.

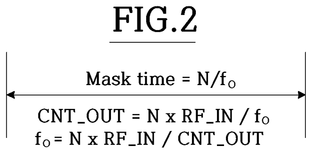

FIG. 2 is a diagram for describing a mask signal MASK for defining a period during which a frequency counter 500 counts an external high-frequency clock. Here, RF_IN denotes a frequency of the external high-frequency clock, N denotes a division ratio of the frequency counter 500, f_{O} denotes an output frequency of a digitally controlled oscillating circuit, and Mask time denotes a size of an activation period of the mask signal MASK. Mask time is a value obtained by dividing the division ratio by the output frequency of the digitally controlled oscillating circuit. An output value of the frequency counter 500 is a value that is N times a ratio of RF_IN to f_{O}. When the output of the digitally controlled oscillating circuit closely matches a target frequency f_{T}, a value of f_{O} becomes a value of NxRF_IN/f_{T}, and this value may be set to be the target count COMP_REF with which the oscillation control circuit 300 compares the output value CNT_OUT of the frequency counter 500.

### <Description of the invention according to claims 2 and 3>

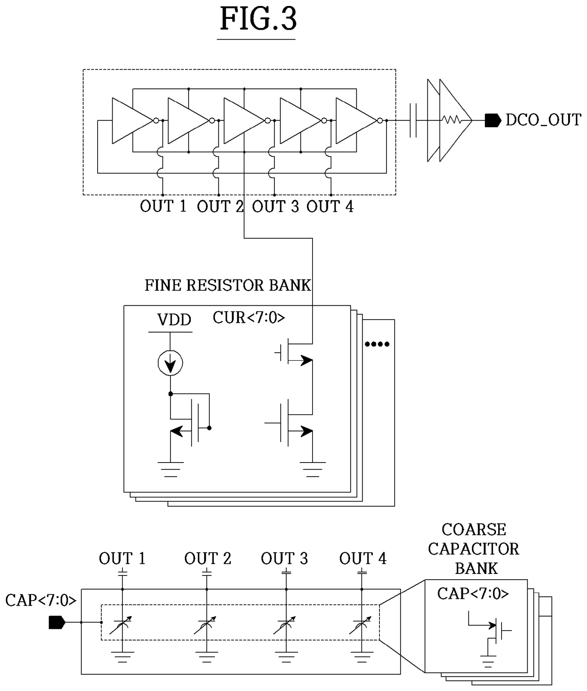

According to another aspect of the present invention, an internal oscillating circuit of the reference clock generating circuit may be divided into a coarse control part and a fine control part. FIG. 3 illustrates a configuration of an embodiment of the digitally controlled oscillating circuit according to this aspect. As illustrated, the digitally controlled oscillating circuit according to an embodiment includes an RC oscillator circuit. A basic RC oscillator circuit is a type of feedback-type oscillator circuit that outputs a sine wave and may adjust an output frequency by changing a charge/discharge time constant of an RC filter connected to an output terminal of an amplifier. In the embodiment illustrated in FIG. 3, the digitally controlled oscillating circuit includes an odd number of inverters.

These inverters are connected to each other in series and have a structure in which an output of a last terminal is feedbacked to an input terminal of a first terminal. A filter composed of a variable capacitor and a variable resistor is connected to the input terminal of each inverter.

As illustrated, a plurality of variable capacitors have a structure in which each terminal is connected to the input terminal of each inverter, the other terminal is connected to a ground terminal, and each capacitance value varies by a coarse control word composed of some bits of a binary oscillation control word. Each bit of the coarse control word may control the connections of the respective capacitors. A total capacitance value is determined by the number of connected capacitors. By forming areas of the capacitors belonging to a coarse capacitor bank differently according to the number of binary digits, it is possible to control the capacitor to have a capacitance value proportional to a value of the binary coarse control word.

A plurality of resistors have a structure in which the plurality of resistors are each turned on or off by each of bits of a fine control word consisting of at least some bits of the remaining bits of the binary oscillation control word, and which are connected to each other in parallel so that one terminal of which is commonly connected to power terminals of the inverters and the other terminal is connected to the ground terminal. The connection of the resistors of the fine resistor bank may be controlled by each bit of the fine control word. A total resistor value is determined by the number of connected resistors. By forming lengths of the resistors belonging to the fine resistor bank differently according to the number of binary digits, it is possible to control the resistor to have a resistance value proportional to a value of the binary fine control word.

### <Description of the invention according to claims 4 and 5>

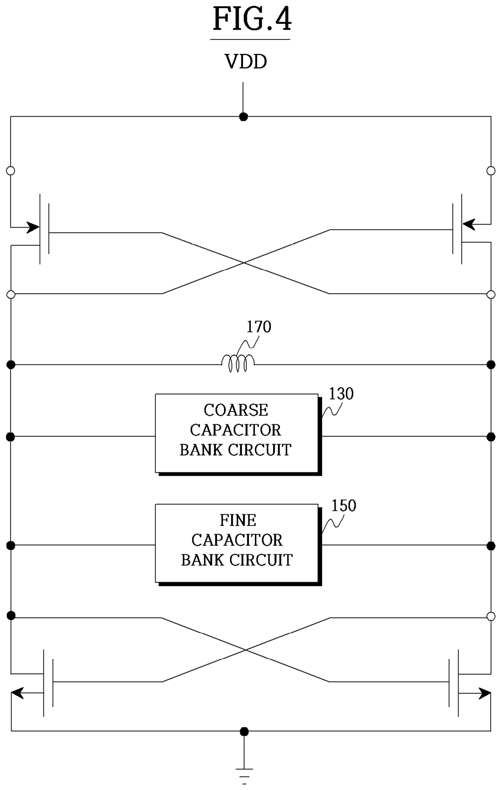

FIG. 4 illustrates a configuration of another embodiment of a digitally controlled oscillating circuit to which this aspect may be applied. As illustrated, a digitally controlled oscillating circuit 100 according to another embodiment includes an LC resonant circuit composed of a variable capacitor including a coarse capacitor bank circuit 130 and a fine capacitor bank circuit 150, and an inductor 170.

The coarse capacitor bank circuit 130 includes a plurality of capacitors and a plurality of switches corresponding thereto that control the parallel connection between the plurality of capacitors. The switching of each switch may be controlled according to a control word input from the outside, here, a coarse control word, and accordingly, the parallel connection between the plurality of capacitors may be controlled. In an embodiment, the coarse capacitor bank circuit 130 may be formed so that the capacitance value of each of its capacitors has a value corresponding to each digit of a binary number. For example, when the coarse capacitor bank circuit 130 includes eight capacitors and C is a constant, an uppermost capacitor may have a capacitance value of C×2⁸, a capacitor below the uppermost capacitor may have a capacitance value of C×2⁷, ..., and a lowermost capacitor may have a capacitance value of C. In this embodiment, the coarse capacitor bank circuit 130 has a capacitance value accurately proportional to a binary number of an 8-bit coarse control word. Since a resonant frequency is inversely proportional to a square root of the capacitance value, the larger the control word, the lower a frequency of an output clock.

The fine capacitor bank circuit 150 includes a plurality of capacitors therein and a plurality of switches corresponding thereto that control parallel connections between the plurality of capacitors. The switching of each switch may be controlled according to a control word input from the outside, here, a fine control word, and accordingly, the parallel connection between the plurality of capacitors may be controlled. In an embodiment, the fine capacitor bank circuit 150 may be formed so that the capacitance value of each of its capacitors has the same value. In this embodiment, the capacitance values of the respective capacitors constituting the fine capacitor bank circuit 150 may be designed to be a value obtained by dividing the lowest capacitor capacitance value of the coarse capacitor bank circuit 130 by 2⁸=256, which is C/2⁸ in this embodiment. Accordingly, the fine capacitor bank circuit 150 has a capacitance value accurately proportional to an 8-bit fine control word LF<7:0>. In the illustrated embodiment, the fine capacitor bank circuit 150 includes 256 capacitors, and 256 switches connected to the respective capacitors so that the capacitance value is proportionally adjusted according to the 8 fine control word. Since a resonant frequency of an LC resonant circuit is inversely proportional to a square root of the capacitance value, the larger the control word, the lower a frequency of an output clock.

### <Description of the invention according to claims 6 and 7>

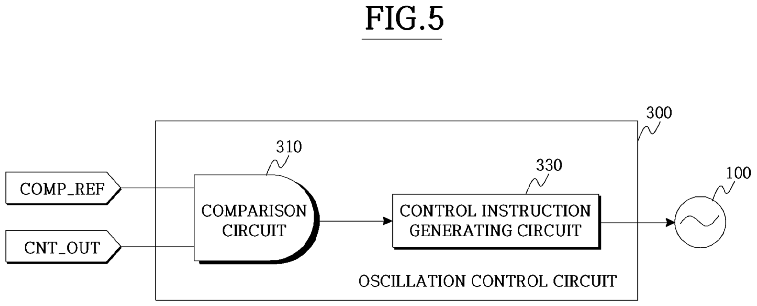

FIG. 5 is a block diagram illustrating a configuration of an oscillation control circuit according to still another embodiment. An oscillation control circuit 300 compares an output value CNT_OUT of a frequency counter 500 with a target count and outputs an oscillation control word according to a result of the comparison. In the illustrated embodiment, the oscillation control circuit 300 includes a comparison circuit 310 and a control instruction generating circuit 330. In the illustrated embodiment, the comparison circuit 310 compares the output value CNT_OUT of the frequency counter with a target count COMP_REF. Such a comparison circuit for digital values is well known.

The control instruction generating circuit 330 generates and outputs an oscillation control word according to an output of the comparison circuit 310. In the illustrated embodiment, the oscillation control word includes a coarse control word and a fine control word. The control instruction generating circuit 330 generates an oscillation control word determined by the count value CNT_OUT of the frequency counter 500 and an internal configuration of the digitally controlled oscillating circuit 100. For example, in the digitally controlled oscillating circuit 100, a value of the frequency counter 500 may vary according to the degree to which an output frequency increases when an input binary control word increases by a unit, and accordingly, the oscillation control word may be determined according to a ratio at which an output value of the comparison circuit 310 changes. Accordingly, similar to the embodiment of FIG. 1, it may be formed so that the larger the oscillation control word, the lower the frequency output by the digitally controlled oscillating circuit 100 and the smaller the oscillation control word, the higher the frequency output by the digitally controlled oscillating circuit 100. According to the operation of the comparison circuit 310, when the output value of the frequency counter 500 is higher than the target count, the oscillation control word may be adjusted to be a larger value, and when the output value of the frequency counter 500 is lower than the target count, the oscillation control word may be adjusted to be a smaller value.

In the illustrated embodiment, the output value CNT_OUT of the frequency counter and the target count COMP_REF are each 18 bits, and the coarse control word and the fine control word are each 8 bits. In the illustrated embodiment, the two 18-bit values are compared bitwise against the lower 16 bits, and results of each bit-by-bit comparison are directly used to construct the 16-bit coarse control word and fine control word. The reason why the output value CNT_OUT of the frequency counter and the target count COMP_REF are two bits longer than the coarse and fine control words is to allow for the count value to have a larger value when the output of the digitally controlled oscillating circuit is not stable. In this embodiment, the control instruction generating circuit 330 may be formed as a simple logic circuit, unlike the previous embodiment, using a comparison circuit for two binary numbers.

### <Description of the invention according to claim 8>

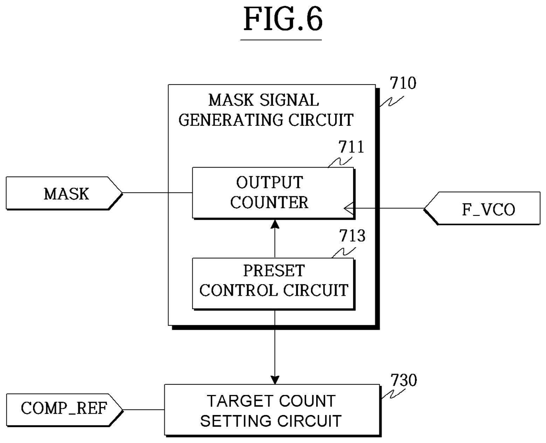

FIG. 6 is a block diagram illustrating a configuration of a locking control circuit according to yet another embodiment. The embodiment of FIG. 6 may be provided with a dedicated logic circuit without including a microprocessor, unlike the locking control circuit in the embodiment of FIG. 1. In the illustrated embodiment, the locking control circuit 700 includes a mask signal generating circuit 710 and a target count setting circuit 730. The mask signal generating circuit 710 increases the activation period of the mask signal MASK when a comparison result difference of the comparison circuit 310 of the oscillation control circuit 300 decreases. In the illustrated embodiment, the mask signal generating circuit 710 may be implemented with an output counter 711, which is a programmable counter circuit that counts the output of the digitally controlled oscillating circuit 100 up to a constant number, and a preset control circuit 713 which is a logic circuit that sets a preset value of the constant number. The preset constant number may be selected as one of a plurality of values, for example, by a multiplexer, according to the output of the comparison circuit 310. Here, a decrease in the comparison result difference of the comparison circuit 310 indicates that the output of the digitally controlled oscillating circuit 100 has reached the frequency of the target reference clock based on the sensing sensitivity of the controller. In one embodiment, the sensing sensitivity of the controller may be adjusted by the mask signal.

The target count setting circuit 730 outputs a target count value determined according to the activation period of the mask signal changed by the mask signal generating circuit 710. For example, the target count setting circuit 730 may be implemented with a register that stores a plurality of digital values and a multiplexer circuit that selects one of the outputs of the register according to the output of the mask signal generating circuit 710. In the illustrated embodiment, the target count setting circuit 730 changes the target count value to a larger value when the mask signal generating circuit 710 adjusts the activation period of the mask signal MASK to be longer. The frequency counter 500 counts the external high-frequency clock input during the activation period of the mask signal MASK, and as a result, the reference clock generating circuit according to the illustrated embodiment controls the output frequency of the digitally controlled oscillating circuit 100 according to a result of comparing the number of pulses output for a longer period of time, and thus the frequencies more precisely match, but the time required for matching becomes longer.

Therefore, the mask signal generating circuit 710 sets the activation period of the mask signal MASK to be short at the beginning of the circuit's operation, and the target count setting circuit also sets the target count value to a corresponding small value. In this case, the reference clock generating circuit according to an embodiment may control the output frequency of the digitally controlled oscillating circuit 100 according to a result of comparing the number of pulses output for a shorter period of time so that the output frequency may be matched to the input target frequency in a short period of time at a rough level. Thereafter, the mask signal generating circuit 710 of the locking control circuit 700 may set the activation period of the mask signal MASK to be longer as the output of the comparison circuit 310 decreases, and accordingly, the target count setting circuit 730 may set the target count value to a corresponding larger value, thereby more precisely matching the output frequency to the target frequency. However, in this case, since the output frequency is already matched to the target frequency at a rough level based on the results of the previous operation, the output frequency may reach the target frequency more rapidly. Such a process may be repeatedly applied multiple times according to the required clock frequency precision.

FIG. 7 is a flowchart for describing an embodiment of an operation of a locking control circuit. As illustrated, a locking control circuit 700 sets an initial value of a mask signal to N (operation S100) and operates the output counter 711 8 times (operation S100). Accordingly, an output of a digitally controlled oscillating circuit 100 becomes unstable, and only a coarse control word, which adjusts a coarse capacitor bank circuit 130 on the basis of an upper 8-bit value, is stabilized through 8 times of operations. Thereafter, the locking control circuit 700 doubles the value of the mask signal (operation S500) and operates the output counter 711 8 times (operation S700). Accordingly, the output of the digitally controlled oscillating circuit 100 becomes stabilized and a fine control word that adjusts a fine capacitor bank circuit 150 on the basis of a lower 8-bit the value is stabilized through 8 times of operations. In an embodiment, in a preset control circuit 713 implemented with a register and a multiplexer in FIG. 5, an output selection signal of the multiplexer is generated and supplied by a sequential logic circuit that implements such logic. In the illustrated embodiment, doubling of the value of the MASK signal is applied one time after eight runs, but the doubling may be repeated multiple times as needed.

### <Description of the invention according to claim 9>

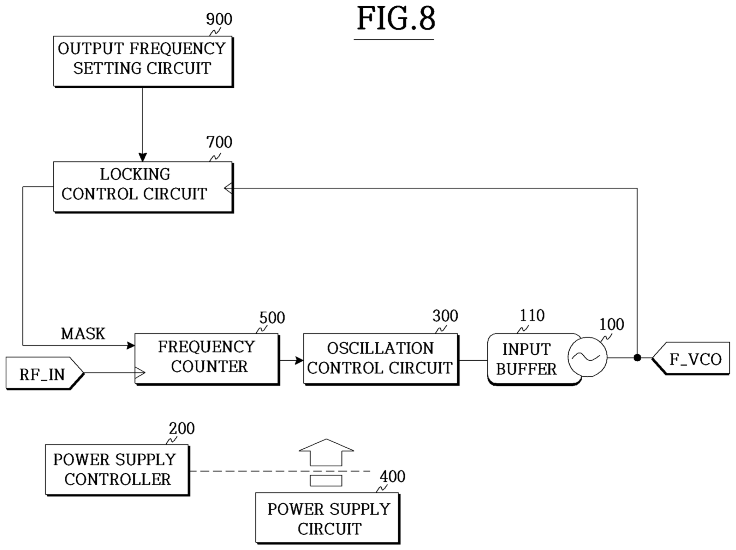

In an additional aspect, the proposed reference clock generating circuit may vary a frequency of an output reference clock by selecting a target count value of a frequency counter and an activation value of a mask signal as one of a plurality of sets according to an operating mode. FIG. 8 is a block diagram illustrating a configuration of a reference clock generating circuit according to yet another embodiment to which this aspect is applied. Similar components to the embodiment of FIG. 1 are referenced by the same reference numerals. In the illustrated embodiment, the reference clock generating circuit further includes an output frequency setting circuit 900. The output frequency setting circuit 900 may store a plurality of sets of pairs of a mask signal control value and the target count value and divide and supply one of the sets to each of a mask signal generating circuit and a target count setting circuit according to an instruction for selecting an output frequency. The instruction for selecting the output frequency may be, for example, an operating mode signal from an internal controller, such as a microprocessor. For example, the microprocessor's activation mode operating clock and sleep mode operating clock may be supplied by a single reference clock generating circuit. In the illustrated embodiment, the mask signal control value may be a preset value of a programmable count.

### <Description of the invention according to claim 10>

In an additional aspect, the reference clock generating circuit may be controlled to block power from being supplied to unnecessary parts of the circuit when the output is stably locked to the target frequency, and the digitally controlled oscillating circuit may be controlled to perform free running by a last input oscillation control word. FIG. 8 is a block diagram illustrating a configuration of a reference clock generating circuit according to yet another embodiment to which this aspect is applied. As illustrated, compared to the embodiment illustrated in FIG. 1, in the illustrated embodiment, the digitally controlled oscillating circuit 100 further includes an input buffer 110 at an input terminal thereof. The input buffer 110 may store an input oscillation control word, and when the oscillation control word is not changed by the oscillation control circuit 300, a value thereof may be maintained and supplied to the inside of the digitally controlled oscillating circuit 100. Accordingly, even when the power being supplied to the remaining circuits of the reference clock generating circuit is blocked and is not operated, the digitally controlled oscillating circuit 100 may operate freely and continue to output the reference clock having a locked frequency.

Additionally, the reference clock generating circuit according to yet another embodiment may further include a power supply controller 200. In an embodiment, the power supply controller 200 blocks power from being supplied to at least some circuits of the remaining circuits except for the digitally controlled oscillating circuit, while an output of the reference clock generating circuit is stably locked to the target frequency, and supplies power to resume the operation thereof according to a condition.

In an embodiment, the power supply controller 200 may block power from being supplied to the locking control circuit 700, the frequency counter 500, and the oscillation control circuit 300 when the output is stably locked to the target frequency and then may supply power to resume the operation thereof according to a condition. In this case, the power supply controller 200 may repeat the operation of periodically resuming the supply of power in response to a timer interruption and blocking the supply of power when the output is stably locked to the target frequency.

As another example, the power supply controller 200 may control the frequency counter 500, the comparison circuit 310, and the digitally controlled oscillating circuit 100 in the reference clock generating circuit according to the embodiment of FIG. 3 to always supply power, block power from being supplied to the remaining circuits when the output is stably locked to the target frequency, and resume the supply of power when the output of the comparison circuit 310 outputs a value other than "0." In this case, the comparison circuit 310 includes a buffer at its input terminal to maintain a last input target count COMP_REF.

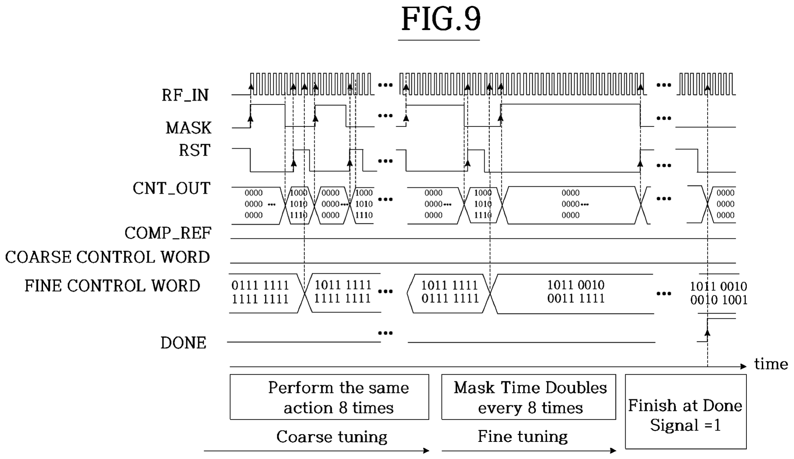

FIG. 9 is a graph for describing an example of the timing of control signals in the embodiments described in FIGS. 1 to 8. As illustrated, the frequency counter 500 counts an external high-frequency clock RF_IN during a period for which a mask signal MASK is activated. The mask signal MASK maintains the same form 8 times, after which the activation period is doubled and also remains in the same form 8 times. During the first 8 times, a coarse control word for adjusting the resonance frequency of the digitally controlled oscillating circuit 100 from an output CNT_OUT of the frequency counter 500 converges to a target value, and during the next 8 times, a fine control word converges to the target value, so that the output frequency of the digitally controlled oscillating circuit 100 precisely matches the target frequency.

According to the proposed invention, a reference clock can be generated by a digitally controlled oscillating circuit using an input synchronization signal. A reference clock generating circuit is composed of elements that can be integrated into an IC, can minimize the number of peripheral components, and thus does not occupy a physical space on a system board.

According to the proposed invention, a window in which a synchronization signal, which is input to control a frequency according to a difference between an output of an oscillating circuit and a target frequency is considered in terms of circuits, can be dynamically controlled, thereby rapidly approaching the target frequency at the beginning, and improving a frequency tracking precision, which is the degree to which the output of the digitally controlled oscillating circuit 100 matches the target frequency.

Further, the reference clock generating circuit according to the proposed invention can generate a reference clock having a frequency determined as one of a plurality of values according to an operating mode.

Further, when an output of the reference clock generating circuit according to the proposed invention is stably locked to a target frequency, it is possible to minimize power consumption by blocking power being supplied to a circuit, performing free running, and performing periodic activation.

While embodiments of the present invention have been described with reference to the accompanying drawings, the present invention is not limited to the embodiments. It should be interpreted that various modifications that can be apparently made by those skilled in the art are included in the scope of the present invention. The appended claims are intended to cover such modified embodiments.

## Claims

1. A reference clock generating circuit comprising:
a frequency counter configured to count an external high-frequency clock received through a wireless channel during a period for which a mask signal is activated;
an oscillation control circuit configured to compare an output value of the frequency counter with a target count and output an oscillation control word according to a result of the comparison;
a digitally controlled oscillating circuit including a circuit element having a characteristic value that varies according to the oscillation control word; and
a locking control circuit configured to dynamically increase an activation period of the mask signal as an output of the digitally controlled oscillating circuit approaches a target frequency.

2. The reference clock generating circuit of claim 1, wherein the digitally controlled oscillating circuit includes a resistor-capacitor (RC) oscillator circuit whose resistance and capacitance values are adjusted according to the oscillation control word.

3. The reference clock generating circuit of claim 2, wherein the RC oscillator circuit includes:
an odd number of inverters connected to each other in series by feedbacking a last output to a first input terminal;
a plurality of variable capacitors, each of which has one terminal connected to an input terminal of each inverter and the other terminal connected to a ground terminal, and each of which has a capacitance value that varies according to a coarse control word consisting of some bits of a binary oscillation control word; and
a plurality of resistors, each of which is turned on or off by each of bits of a fine control word consisting of at least some bits of the remaining bits of the binary oscillation control word, and which are connected to each other in parallel so that one terminal of each of the resistors is commonly connected to power terminals of the inverters and the other terminal is connected to the ground terminal.

4. The reference clock generating circuit of claim 1, wherein the digitally controlled oscillating circuit, which is a digitally controlled resonant circuit that oscillates a clock signal having a frequency determined by electric resonance between at least two circuit elements, includes:
a coarse bank circuit including a circuit element having a characteristic value that varies according to a coarse control word consisting of some bits of a binary oscillation control word; and
a fine bank circuit including a circuit element having a characteristic value that varies according to a fine control word consisting of at least some bits of the remaining bits of the binary oscillation control word, wherein the characteristic value varies within a smaller range than the coarse bank circuit.

5. The reference clock generating circuit of claim 4, wherein the coarse bank circuit and the fine bank circuit each include capacitor circuit elements and switches that control a connection between the capacitor circuit elements.

6. The reference clock generating circuit of claim 1, wherein the oscillation control circuit includes:
a comparison circuit that compares the output value of the frequency counter with the target count; and
a control instruction generating circuit that generates and outputs the oscillation control word according to an output of the comparison circuit.

7. The reference clock generating circuit of claim 1, wherein the oscillation control circuit includes:
a comparison circuit that compares the output value of the frequency counter with the target count; and
a control instruction generating circuit that generates and outputs the oscillation control word including a coarse control word and a fine control word according to an output of the comparison circuit.

8. The reference clock generating circuit of claim 1, wherein the locking control circuit includes:
a mask signal generating circuit that increases an activation period of the mask signal when a comparison result difference of the oscillation control circuit decreases; and
a target count setting circuit that outputs a target count value determined according to the activation period of the mask signal that is changed by the mask signal generating circuit.

9. The reference clock generating circuit of claim 8, further comprising an output frequency setting circuit that stores a plurality of sets of pairs of a mask signal control value and the target count value, and divides and supplies one of the sets to each of the mask signal generating circuit and the target count setting circuit according to an instruction for selecting an output frequency.

10. The reference clock generating circuit of claim 1, wherein the digitally controlled oscillating circuit further includes an input buffer that stores the input oscillation control word, and
the reference clock generating circuit further includes a power supply controller that blocks power from being supplied to at least some circuits of the remaining circuits except for the digitally controlled oscillating circuit while an output of the reference clock generating circuit is stably locked to the target frequency, and supplies power to resume operation of the at least some circuits according to a condition.
